# EUROPÄISCHE PATENTANMELDUNG

(11) **EP 2 418 298 A1**
(43) Veröffentlichungstag der Anmeldung: **15.02.2012**
(21) Anmeldenummer: 11006445.8
(22) Anmeldetag: 05.08.2011
(51) Int. Cl.: C23C 14/00, C23C 14/06, C23C 14/32

(54) **Verfahren zur Herstellung einer Harstoffbeschichtung auf metallischen, keramischen oder hartmetallischen Bauteilen sowie eine mit dem Verfahren hergestellte Hartstoffbeschichtung**

(30) Priorität: 09.08.2010 DE 102010034321
(71) Anmelder: Fraunhofer-Gesellschaft zur Förderung der angewandten Forschung e.V., 80686 München (DE); Technische Universität Dresden, 01069 Dresden (DE)
(72) Erfinder: Zimmer, Otmar, Dr., 01157 Dresden (DE); Kaulfuss, Frank, 01259 Dresden (DE)
(74) Vertreter: Pfenning, Meinig & Partner GbR

(57) **Zusammenfassung**

Die Erfindung betrifft ein Verfahren zur Herstellung einer Hartstoffbeschichtung auf metallischen, keramischen oder hartmetallischen Bauteilen sowie eine mit dem Verfahren hergestellte Hartstoffbeschichtung. Mit dem Verfahren werden Hartstoffbeschichtungen, die mit AlCrN, AlCrSiN, AlTiN, AlTiSiN, AlCrN/TiN, AlCrSiN/TiN, AlZrN/ZrN oder AlCrSiN/ZrN gebildet sind, hergestellt. Die Beschichtungen weisen eine Schichtdicke von mindestens 50 µm auf. Sie werden mit einem PVD-Verfahren, bei dem innerhalb einer Vakuumkammer, in der ein Stickstoffpartialdruck > 2,5 Pa, bevorzugt > 5 Pa eingehalten wird, ausgebildet. Dabei wird mit mindestens eine die metallischen Elemente der Beschichtung, und bei einer Beschichtung, in der auch Silizium enthalten ist, eine auch Silizium enthaltende Verdampferquelle betrieben. Während der Ausbildung der Beschichtung wird an das zu beschichtende Bauteil eine elektrisch negative BIAS-Spannung von mindestens 250 V, bevorzugt mindestens 300 V besonders bevorzugt 500 V angelegt.

## Beschreibung

Die Erfindung betrifft ein Verfahren zur Herstellung einer Hartstoffbeschichtung auf metallischen, keramischen oder hartmetallischen Bauteilen sowie eine mit dem Verfahren hergestellte Hartstoffbeschichtung.

Solche Hartstoffbeschichtungen werden für Werkzeuge und andere Bauteile seit geraumer Zeit genutzt, um deren Standzeiten zu erhöhen und das Verschleißverhalten zu verbessern. Häufig werden die Beschichtungen mit bekannten Dünnschichtverfahren, wie z.B. PVD-oder CVD-Verfahren im Vakuum hergestellt. Die Beschichtungswerkstoffe sind dabei unterschiedliche Nitride, Boride oder auch Oxide. Bei Schneidwerkzeugen sind z.B. TiN, AlTiN, AlCrN u.a. als Beschichtungswerkstoff bekannt. Die mit den genannten Verfahren hergestellten Beschichtungen können aber nur mit sehr geringer Schichtdicke im Bereich von maximal 20 µm hergestellt werden, ohne dass erheblich störende Defekte auftreten. Problematisch sind auch die Eigenspannungen in den Beschichtungen, die zu einem vorzeitigen Verschleiß oder gar Zerstörung der bekannten Hartstoffbeschichtungen führen können. Bei den bisher erreichbaren dünnen Hartstoffschichten ergibt sich auch ein weiterer Nachteil durch die geringe Schichtdicke. Diese schließt eine im Anschluss an die Ausbildung der Beschichtung häufig gewünschte Oberflächenbearbeitung aus, mit der die Güte der Oberfläche verbessert wird. Es kann auch keine Nachbearbeitung nach einer bereits erfolgten Benutzung eines Bauteils durchgeführt werden. So ist beispielsweise ein Nachschleifen oder auch Polieren nicht möglich, ohne die Beschichtung in unerwünschter Form zu beschädigen.

Es wächst daher immer mehr der Wunsch der Anwender nach mit Hartstoffbeschichtungen versehenen Bauteilen, bei denen die Hartstoffschichten neben einer hohen Härte, auch kleine Schichteigenspannungen bei gleichzeitig erhöhter Schichtdicke aufweisen und dabei mit einem Vakuumbeschichtungsverfahren hergestellt worden sind.

Es ist daher Aufgabe der Erfindung, Möglichkeiten anzugeben, Bauteile zur Verfügung zu stellen, deren Hartstoffbeschichtung eine erhöhte Schichtdicke, bei hoher Härte und kleineren Schichteigenspannungen aufweist.

Erfindungsgemäß wird diese Aufgabe mit einem Verfahren, das die Merkmale des Anspruchs 1 aufweist, gelöst. Der Patentanspruch 9 betrifft eine mit dem Verfahren hergestellte Hartstoffbeschichtung. Vorteilhafte Ausgestaltungen der Erfindung können mit in untergeordneten Ansprüchen bezeichneten technischen Merkmalen realisiert werden.

Bei dem erfindungsgemäßen Verfahren werden Hartstoffbeschichtungen auf metallischen, keramischen oder hartmetallischen Bauteilen, die mit AlCrN, AlCr(Si)N, AlTiN, AlTi(Si)N, AlCrN/TiN, AlCr(Si)N/TiN, AlCrN/ZrN oder AlCr(Si)N/ZrN gebildet sind, hergestellt. Sie sollen dabei eine Schichtdicke von mindestens 50 µm, bevorzugt eine größere Schichtdicke aufweisen.

Die Herstellung erfolgt mit einem PVD-Verfahren in einer Vakuumkammer, in der ein Stickstoffpartialdruck > 2,5 Pa, bevorzugt > 5 Pa eingehalten wird. Es hat sich als günstig herausgestellt, als Verdampferquelle eine oder mehrere Vakuumbogenverdampfer, bevorzugt mit einer Graphitanode oder einer überwiegend (> 50-Masse-%) mit Graphit gebildeten Anode, in der mindestens eine weitere Komponente enthalten ist, einzusetzen. Das Verfahren soll mit mindestens einer, die metallischen Elemente der Beschichtung enthaltenden und bei einer Beschichtung, in der auch Silizium enthalten ist, eine Silizium enthaltende Verdampferquelle betrieben werden, um die Beschichtung auf der Bauteiloberfläche auszubilden. Zumindest während der Ausbildung der Beschichtung wird an das zu beschichtende Bauteil eine elektrisch negative BIAS-Spannung von mindestens 250 V, bevorzugt mindestens 300 V, besonders bevorzugt 500 V angelegt. Dies bedeutet, dass eine solche elektrische BIAS-Spannung zumindest zu Zeiten an das Bauteil angelegt ist, bei denen ein Schichtwachstum auftritt. Es können dazwischen jedoch Phasen beim Betrieb der Verdampferquelle(n) auftreten, bei denen keine oder eine andere elektrische BIAS-Spannung am Bauteil anliegt. Dies kann beispielsweise immer dann der Fall sein, wenn eine Voroder Zwischenbehandlung für eine Beeinflussung der bereits ausgebildeten Beschichtung, auch vor dem Erreichen der maximal gewünschten Schichtdicke, der Beschichtung durchgeführt wird.

Die Eigenschaften des Beschichtungswerkstoffs der fertig hergestellten Hartstoffbeschichtung können auch unmittelbar während des eigentlichen Beschichtungsprozesses beeinflusst werden. Dabei kann/können während der Ausbildung der Beschichtung zumindest einer der folgenden Parameter, nämlich die elektrische BIAS-Spannung, der Stickstoffpartialdruck und/oder die Geschwindigkeit, mit der ein Bauteil bewegt wird, verändert werden. Bei der Veränderung der Geschwindigkeit kann dies die Geschwindigkeit sein, mit der zu beschichtende Bauteile oder zu beschichtende Oberflächenbereiche an einer oder mehreren Verdampferquellen vorbei bewegt wird/werden. Durch die sich verändernden Abstände der zu beschichtenden Oberflächenbereiche eines Bauteils können die jeweiligen Anteile der chemischen Elemente, mit denen zu diesen Zeitpunkten die Beschichtung ausgebildet wird, variieren. Wenn mehrere Verdampferquellen eingesetzt werden, können deren Kathoden eine unterschiedliche chemische Zusammensetzung aufweisen.

Dadurch kann die Konsistenz der ausgebildeten Hartstoffbeschichtung während des Beschichtungsprozesses variiert werden. Dies erfolgt aber so, dass keine Grenzschichtbildung innerhalb der Hartstoffbeschichtung auftritt, sondern ein sehr fein gradierter Übergang beim Schichtwachstum erreicht werden kann.

Bei sich veränderndem Stickstoff-Partialdruck kann der Nitridanteil innerhalb der Beschichtung verändert werden.

Eine Veränderung der an das Bauteil angelegten elektrischen BIAS-Spannung kann zur Beeinflussung der Kristallitbildung und der Schichteigenspannungen beitragen. Dabei sollten jedoch die für die Bildung der Hartstoffbeschichtung eingesetzten Ionen Energien bis 1 keV aufweisen. Mit diesen Ionenenergien ist ein permanenter Abtrag instabiler Phasen von der Oberfläche der Hartstoffbeschichtung bereits während des Beschichtungsprozesses möglich, so dass keine oder zumindest deutlich weniger und kleinere Defekte auftreten können.

Bei einer Art einer bereits angesprochenen Zwischenbehandlung zum Abbau von Schichteigenspannungen kann in Phasen zwischen der Ausbildung der Beschichtung die bereits ausgebildete Beschichtung durch Anlegen einer elektrisch positiven BIAS-Spannung an das Bauteil mit Elektronen beschossen werden. Der absolute Betrag der elektrischen BIAS-Spannung kann in diesem Fall aber kleiner sein, als die negative elektrische BIAS-Spannung. Es können elektrische Spannungen um ca. 30 V ausreichen, um Elektronen in ausreichendem Maß in Richtung Oberfläche beim Beschießen zu beschleunigen.

Eine Zwischenbehandlung zur Einebnung der Oberfläche und zum Beenden des Kristallwachstums in anderer Form, als mit dem Elektronenbeschuss, kann ein Beschuss der Beschichtungsoberfläche mit Ionen, die eine Energie im Bereich 1 keV bis 2 keV aufweisen, durchgeführt werden.

Vor und nach einer dieser Zwischenbehandlungen kann das Verfahren wieder so betrieben werden, dass ein Schichtwachstum für die Ausbildung der Hartstoffbeschichtung erreicht wird.

Die erfindungsgemäß hergestellte Hartstoffbeschichtung weist eine Härte von mindestens 2500 HV auf. Die Eigenspannungen der Beschichtung sind kleiner 2 GPa und es ist eine feinkristalline Struktur mit Korngrößen kleiner 100 nm eingehalten. Innerhalb der Beschichtung variieren die Anteile der einzelnen die Beschichtung bildenden chemischen Elemente, wie dies bereits angesprochen worden ist. Dies trifft auf die mit AlCrN, AlCrSiN, AlTiN, AlTiSiN, AlCr/TiN, AlCrSiN/TiN, AlCrN/ZrN oder AlCrSiN/ZrN gebildeten Hartstoffbeschichtungen zu.

So können innerhalb der Beschichtung Bereiche mit einer inhomogenen Verteilung der chemischen Elemente erreicht werden. Beispielsweise können Bereiche mit erhöhtem Anteil an AlCrSiN neben Bereichen mit erhöhtem Anteil an TiN auftreten. Insbesondere der Anteil an Si kann stärker variieren, wobei es sogar Bereiche geben kann, in denen kein Si vorhanden ist. Überwiegend bilden solche Bereiche übereinander ausgebildete sehr dünne Schichten mit Dicken im Bereich 3 nm bis 50 nm. Dabei sind die einzelnen Schichten nicht scharf in ihrer Konsistenz voneinander getrennt, sondern es sind Mischzonen ausgebildet, in denen sich die Anteile der chemischen Elemente nur in sehr geringem Maß unterscheiden.

Bei der Erfindung kann eine Stabilisierung der eigentlichen kubischen AlN-Phase durch das Titan erreicht und dabei eine Bildung von hexagonalem AlN durch eine geeignete Zusammensetzung der in den Verdampferquellen eingesetzten Kathoden zumindest nahezu vermieden werden. Wird der Anteil an Titan in der Beschichtung im Bereich 10 Masse-% bis 20 Masse-% gehalten, wirkt sich dies mit einer Reduzierung der Schichteigenspannungen vorteilhaft aus.

Da mit der Erfindung neben bessere Eigenschaften aufweisenden, auch Hartstoffbeschichtungen zur Verfügung gestellt werden können, die Schichtdicken deutlich oberhalb 50 µm bis hin zu 150 µm und mehr, aufweisen, besteht auch die Möglichkeit der Durchführung einer Oberflächenbearbeitung unmittelbar im Anschluss an die Herstellung oder auch nach einer Betriebsphase eines entsprechend beschichteten Bauteils.

Im Anschluss an die Herstellung kann beispielsweise ein Schärfen einer Schneidkante eines mit Hartstoffbeschichtung versehenen Bauteils durch Schleifen durchgeführt werden.

Die erfindungsgemäßen Hartstoffbeschichtungen können auf unterschiedliche Bauteile aus unterschiedlichen Metallen und Legierungen, Keramiken oder auch Hartmetallen aufgebracht werden. Lediglich eine mit AlCrSiN/TiN gebildete Hartstoffbeschichtung sollte nur auf temperaturbeständige Materialien, z.B. Hartmetall, ausgebildet werden. Dies kann Wolframcarbid oder Wolframcarbid mit Cobalt, in denen unterschiedliche aber für Hartmetall übliche Anteile der chemischen Elemente enthalten sind, sein.

Nachfolgend soll die Erfindung beispielhaft näher erläutert werden.

### Beispiel 1:

Für die Herstellung von Bauteilen, die aus Wolframcarbid-Cobalt als Hartmetall gebildet und mit einer

50 µm Hartstoffschicht aus AlCr(si)N/TiN beschichtet werden sollten, ist wie folgt vorgegangen worden. Der Bauteilwerkstoff hatte dabei die Zusammensetzung 90 Masse-% Wolframcarbid und 10 Masse-% Cobalt.

Die Hartmetallbauteile wurden vor dem Beschichten in einem ein alkalisches Reinigungsmittel enthaltendes Bad gegeben und mittels Ultraschall gereinigt. Danach wurden die Bauteile klar gespült und getrocknet.

Die so vorgereinigten Bauteile wurden in eine Vakuumkammer eingesetzt, in der der Innendruck unterhalb 0,01 Pa reduziert wurde.

Die Bauteile wurden in einen drehbaren Bauteilträger eingesetzt. In der Vakuumkammer wurden die Bauteile auf eine Temperatur von 300 °C erwärmt, um ggf. noch vorhandene organische Rückstände von der Oberfläche zu entfernen. Hierfür wurde ein Heizstrahler genutzt.

Im Anschluss an diese Vorwärmung wurde die zu beschichtende Oberfläche durch Ionenbeschuss fein gereinigt. Dabei wurden folgende Parameter eingehalten: pAr = 5 Pa, BIAS-Spannung = -1 kV und t = 20 min.

Zuerst wurde auf der Oberfläche eine ca. 100 nm Dicke Haftvermittlerschicht aus TiN aufgebracht. Dabei wurde eine Verdampferquelle, bei der die Kathode aus reinem Titan bestand, mittels elektrischer Bogenentladung betrieben. Während der elektrischen Bogenentladung wurde die elektrische Spannung auf 20 V und der elektrische Bogenstrom auf 100 A gehalten. An die Bauteile wurde eine negative elektrische BIAS-Spannung von -500 V angelegt. Es wurde der Stickstoffpartialdruck auf 1 Pa eingestellt und die Bauteile mittels des Bauteilträgers an der

### Verdampferquelle vorbei bewegt.

Im Anschluss an die Ausbildung dieser Haftvermittlerschicht wurde bei ansonsten gleichen Bedingungen, eine zweite Verdampferquelle in Betrieb genommen, bei der die Kathode aus AlCrSi (60:30:10 at-%) gebildet war.

Nach dem Zünden der elektrischen Bogenentladung dieser Verdampferquelle, bei der die Anode eine Graphitelektrode war, wurden die Bauteile mittels des Bauteilträgers an den beiden Verdampferquellen vorbeigedreht. Die elektrische Bogenentladung der zweiten Verdampferquelle wurde mit einer elektrischen Spannung von 20 V und einem elektrischen Bogenstrom von 100 A aufrechterhalten.

Dadurch und in Verbindung mit der an die Bauteile angelegten BIAS-Spannung konnte ein Beschuss mit Ionen, deren Energie bei 0,7 keV lag, und eine Beschichtungsrate von 15 µm/h bis 20 µm/h erreicht werden.

Nach einer Abkühlphase von 30 min konnten die mit der Hartstoffbeschichtung versehenen Bauteile entnommen werden.

Mit der 50 µm dicken Hartstoffbeschichtung aus AlCrSi/TiN war eine Härte der Hartstoffbeschichtung von 2900 HV erreicht. Bei diesem Beispiel konnten die günstigen Variationen innerhalb der Hartstoffbeschichtung, wie im allgemeinen Teil der Beschreibung erwähnt, durch die rotierende Bewegung der Bauteile an den beiden Verdampferquellen vorbei, erreicht werden.

Die Hartstoffschicht hatte eine gute Zähigkeit, was auf die inhomogene Zusammensetzung innerhalb der Beschichtung und durch eine in Folge des enthaltenen Anteils an Silizium erreichte Kornfeinung zurück zu führen ist. Die damit bewirkte verminderte Texturbildung innerhalb von Schichtlagen der Beschichtung kann ebenfalls auf das Silizium zurück geführt werden, so dass auch Wachstumsdefekte weitestgehend vermieden werden, die beim Stand der Technik besonders nachteilig waren.

### Beispiel 2:

Für die Herstellung von Bauteilen, die aus Wolframcarbid-Cobalt, als Hartmetall, gebildet und mit einer 50 µm Hartstoffschicht aus AlZrN/ZrN beschichtet werden sollten, ist wie folgt vorgegangen worden. Der Bauteilwerkstoff hatte dabei die Zusammensetzung 90 Masse-% Wolframcarbid und 10 Masse-% Cobalt.

Die Hartmetallbauteile wurden vor dem Beschichten in einem ein alkalisches Reinigungsmittel enthaltendes Bad gegeben und mittels Ultraschall gereinigt. Danach wurden die Bauteile klar gespült und getrocknet. Die so vorgereinigten Bauteile wurden in eine Vakuumkammer eingesetzt, in der der Innendruck auf kleiner 0,01 Pa reduziert wurde.

Die Bauteile wurden in einen drehbaren Bauteilträger eingesetzt. In der Vakuumkammer wurden die Bauteile auf eine Temperatur von 300 °C erwärmt, um ggf. noch vorhandene organische Rückstände von der Oberfläche zu entfernen. Hierfür wurde ein Heizstrahler genutzt.

Im Anschluss an diese Vorwärmung wurde die zu beschichtende Oberfläche durch Ionenbeschuss fein gereinigt. Dabei wurden folgende Parameter eingehalten:
pAr = 5 Pa, BIAS-Spannung = -1 kV und t= 20 min.

Zuerst wurde auf der Oberfläche eine ca. 100 nm Dicke Haftvermittlerschicht aus ZrN aufgebracht. Dabei wurde eine Verdampferquelle, bei der die Kathode aus reinem Zirkonium bestand, mittels elektrischer Bogenentladung betrieben. Während der elektrischen Bogenentladung wurden die elektrische Spannung auf 20 V und der elektrische Bogenstrom auf 100 A gehalten. An die Bauteile wurde eine negative elektrische BIAS-Spannung von -500 V angelegt. Es wurde der Stickstoffpartialdruck auf 1 Pa eingestellt und die Bauteile mittels des Bauteilträgers an der Verdampferquelle vorbei bewegt.

Im Anschluss an die Ausbildung dieser Haftvermittlerschicht wurde bei ansonsten gleichen Bedingungen, eine zweite Verdampferquelle in Betrieb genommen, bei der die Kathode aus AlCr (70:30 at-%) gebildet war.

Nach dem Zünden der elektrischen Bogenentladung dieser Verdampferquelle, bei der die Anode eine Graphitelektrode war, wurden die Bauteile mittels des Bauteilträgers an den beiden Verdampferquellen vorbeigedreht. Die elektrische Bogenentladung der zweiten Verdampferquelle wurde mit einer elektrischen Spannung von 20 V und einem elektrischen Bogenstrom von 100 A aufrechterhalten.

Dadurch und in Verbindung der an die Bauteile angelegten BIAS-Spannung konnte ein Beschuss mit Ionen, deren Energie bei 0,7 ekV lag und eine Beschichtungsrate von 15 µm/h bis 20 µm/h erreicht werden.

Nach einer Abkühlphase von 30 min konnten die mit der Hartstoffbeschichtung versehenen Bauteile entnommen werden.

Mit der 50 µm dicken Hartstoffbeschichtung aus AlCrN/ZrN war eine Härte der Hartstoffbeschichtung von 3000 HV erreicht. Bei diesem Beispiel konnten die günstigen Variationen innerhalb der Hartstoffbeschichtung, wie im allgemeinen Teil der Beschreibung erwähnt, durch die rotierende Bewegung der Bauteile an den beiden Verdampferquellen vorbei erreicht werden.

Die Hartstoffschicht hatte eine gute Zähigkeit, was auf die inhomogene Zusammensetzung innerhalb der Beschichtung zurück zu führen ist. Auch Wachstumsdefekte können weitestgehend vermieden werden, die beim Stand der Technik besonders nachteilig waren.

## Patentansprüche

1. Verfahren zur Herstellung einer Hartstoffbeschichtung auf metallischen, keramischen oder hartmetallischen Bauteilen, die mit AlCrN, AlCr(Si)N, AlTiN, AlTi(Si)N, AlCrN/TiN, AlCr(Si)N/TiN, AlCrN/ZrN oder AlCr(Si)N/ZrN gebildet ist, und eine Schichtdicke von mindestens 50 µm aufweist, mit einem PVD-Verfahren, bei dem innerhalb einer Vakuumkammer, in der ein Stickstoffpartialdruck > 2,5 Pa, bevorzugt > 5 Pa eingehalten wird, mindestens eine die metallischen Elemente in der Beschichtung, und bei einer Beschichtung in der auch Silizium enthalten ist, eine Silizium enthaltende Verdampferquelle betrieben wird, um die Beschichtung auf der Bauteiloberfläche auszubilden; wobei zumindest während der Ausbildung der Beschichtung an das zu beschichtende Bauteil eine elektrisch negative BIAS-Spannung von mindestens 250 V, bevorzugt 500 V angelegt wird.

2. Verfahren nach Anspruch 1, **dadurch gekennzeichnet, dass** als Verdampferquelle(n) ein Vakuumbogenverdampfer eingesetzt wird.

3. Verfahren nach Anspruch 1 oder 2, **dadurch gekennzeichnet, dass** während der Ausbildung der Beschichtung die elektrische BIAS-Spannung, der Stickstoffpartialdruck und/oder die Geschwindigkeit, mit der ein Bauteil bewegt wird, verändert wird.

4. Verfahren nach einem der vorhergehenden Ansprüche, **dadurch gekennzeichnet, dass** als Verdampferquelle(n) ein Vakuumbogenverdampfer mit einer Graphitanode oder einer überwiegend mit Graphit gebildeten Anode eingesetzt wird.

5. Verfahren nach einem der vorhergehenden Ansprüche, **dadurch gekennzeichnet, dass** die Ausbildung der Beschichtung so durchgeführt wird, dass die für die Bildung eingesetzten Ionen Energien im Bereich 0,5 keV bis 1 keV aufweisen.

6. Verfahren nach einem der vorhergehenden Ansprüche, **dadurch gekennzeichnet, dass** bei einer Zwischenbehandlung zum Abbau von Schichteigenspannungen, in Phasen zwischen der Ausbildung der Beschichtung, die bereits ausgebildete Beschichtung, durch Anlegen einer elektrisch positiven BIAS-Spannung an das Bauteil, mit Elektronen beschossen wird.

7. Verfahren nach einem der vorhergehenden Ansprüche, **dadurch gekennzeichnet, dass** bei einer weiteren Zwischenbehandlung zur Einebnung der Oberfläche und zum Beenden des Kristallwachstums ein Beschuss mit Ionen, die eine Energie im Bereich 1 keV bis 2 keV aufweisen, durchgeführt wird.

8. Verfahren nach einem der vorhergehenden Ansprüche, **dadurch gekennzeichnet, dass** in mehreren Verdampferquellen in jeder Verdampferquelle für die Ausbildung der Beschichtung jeweils unterschiedliche chemische Elemente und/oder die chemischen Elemente mit unterschiedlichen Anteilen eingesetzt werden.

9. Hartstoffbeschichtung hergestellt mit einem Verfahren nach einem der vorhergehenden Ansprüche, **dadurch gekennzeichnet, dass** die Beschichtung eine Härte von mindestens 2500 HV aufweist, dabei die Eigenspannung der Beschichtung kleiner 2 GPa und eine feinkristalline Struktur mit Korngrößen kleiner 100 nm eingehalten ist und innerhalb der Beschichtung die Anteile der einzelnen die Beschichtung bildenden chemischen Elemente variiert sind.

10. Hartstoffbeschichtung nach Anspruch 9, **dadurch gekennzeichnet, dass** der Anteil an in der Beschichtung enthaltenem Titan oder Zirkon im Bereich 10 Masse-% bis 20 Masse-% gehalten ist.
